Europäisches Patentamt

European Patent Office

Office européen des brevets

(19)

(11) Publication number: **0 182 587**
**B1**

(12) # EUROPEAN PATENT SPECIFICATION

(45) Date of publication of the patent specification:
**20.09.89**

(51) Int. Cl.⁴: **G03F 7/10**, G03F 7/08

(21) Application number: **85308229.5**

(22) Date of filing: **12.11.85**

(54) A photo resist and a process for manufacturing an integrated circuit.

(30) Priority: **16.11.84 US 672303**

(43) Date of publication of application:
**28.05.86 Bulletin 86/22**

(45) Publication of the grant of the patent:
**20.09.89 Bulletin 89/38**

(84) Designated Contracting States:
**DE FR GB**

(56) References cited:
**EP-A-0 002 105**
**EP-A-0 027 180**
**EP-A-0 067 954**
**DE-B-1 097 273**
**FR-A-2 255 629**
**US-A-4 196 003**

**SOVIET INVENTIONS ILLUSTRATED, section CHPH,
week 8516, 29th May 1985, no. 85-097326/16, Derwent
Publications Ltd., London, GB; & SU-A-11 15 010 (CHEM
PHOTO IND RES) 23-09-1984**
**PATENT ABSTRACTS OF JAPAN, vol. 10,
no. 140 (P-458)[2197], 23rd May 1986; &
JP-A-60 260 037 (NIPPON DENKI K.K.) 23-12-1985**
**PATENT ABSTRACTS OF JAPAN, vol. 4,
no. 100 (P-19)[582], 18th July 1980; &
JP-A-55 59 456 (FUJI SHASHIN FILM K.K.) 02-05-1980**

(73) Proprietor: **International Business Machines
Corporation, Old Orchard Road, Armonk, N.Y. 10504(US)**

(72) Inventor: **Brown, Karen Hill, 2506 Dunning Drive,
Yorktown Heights New York 10598(US)**

(74) Representative: **Hobbs, Francis John, IBM United
Kingdom Limited Intellectual Property Department
Hursley Park, Winchester Hampshire SO21 2JN(GB)**

## Description

This invention relates to a process for manufacturing an integrated circuit by using a photoresist.

Photoresists commonly used in semiconductor integrated circuit device fabrication are excellent insulators, and as such are very susceptible to charge buildup during high voltage processes such as reactive ion etching (RIE) or plasma etching. At the time of filing this patent specification, production of integrated circuits commonly involves numerous photoresist mask patterning steps to control etching of metal or semiconductor to precise patterns. Etching of metals is easy; etching of semiconductors is not difficult; but etching of insulators is very difficult. Rather than resorting to etching of insulators, it is common to convert the patterns to stencil masks and vapour deposit the insulator patterns through stencil masks. There is very little patterning of insulation by etching; stencilling is the common approach.

As the industry progresses towards higher levels of integration, films required for high level integration devices must meet closer tolerances, and it becomes necessary to consider patterning of insulation by etching rather than stencilling. Reactive ion etching (RIE) and plasma etching are examples of etching techniques appropriate to such insulation patterning. Such techniques require high voltages, often in vacuum, in environments which may damage integrated circuit process intermediates as a result of charge buildup on the surfaces of the integrated circuits. Such damage may be inchoate; actual failure or even testability may be months in the future. Failure mechanisms affected by charge buildup include "SiO bumps", "resistor blowout", and a corrosion known as "black death". Charge buildup can also affect the accuracy of e-beam patterning of photoresist, by defocussing the beam in a manner analogous to that of a deflection plate in a cathode ray tube.

Photoresists commonly used in semiconductor (and other) device fabrication are excellent insulators. Current practice involves use of photoresist in many patterning steps such as metal or insulator patterning by either lift-off or RIE/plasma etch subtractive patterning. Evaporation of metals is commonly done using e-beam evaporation or e-beam heating or a crucible containing source material. Plasma precleans are common where metal-metal contacts are important or for improved metal-metal, insulator-metal adhesion. Each of these processes may cause charge buildup on the resist. The charge may cause extensive damage to underlying material and/or circuits.

EP-A 0 067 954 discloses a photoresist comprising a photoresistivity complexing agent and an amine photoconductivity complexing agent.

The invention seeks to provide a process which avoids charge buildup during fabrication of integrated circuits using photoresists.

The invention provides a process for manufacturing an integrated circuit comprising the steps of providing a photoresist layer on an integrated circuit process intermediate and subsequently treating the integrated circuit process intermediate, with photoresist layer, to a patterning process step by mounting it on an attachment mechanism for processing in an environment of significant electric potential; the method being characterised, according to the invention, by the photoresist comprising a diazo ketone photosensitivity complexing agent and an amine photoconductivity complexing agent of low ionisation potential and such that the photoconductivity and photosensivity peaks of the photoresist are at different wavelengths; and means connecting the photoresist layer to a drain electrode at a reference potential, for charges resulting from the environment of significant electric potential.

How the invention can be carried out will now be described by way of example, with reference to the accompanying drawings, in which:

Figure 1 represents an integrated circuit disposed in a reactive ion etching chamber; and

Figure 2 through 4 illustrate various failure mechanisms due to built-up charges; these failure mechanisms are respectively known as "SiO bumps", "resistor blowout" and "black death". The photoconductive photoresist complex serves to bleed charges off to the electrodes of the processing equipment. Built-up charges do not develop and thus do not produce the strong electrical forces resulting in the failure mechanisms.

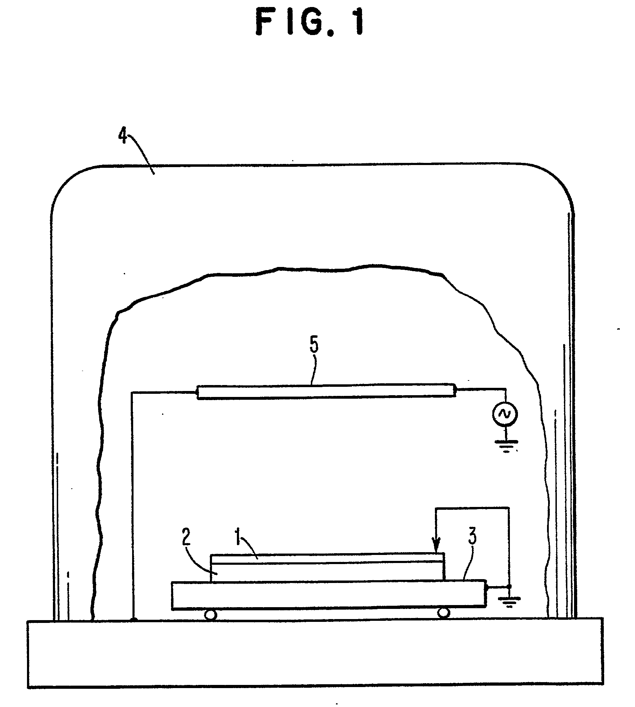

In Figure 1, a photoconductive photoresist 1 (shown greatly enlarged) on integrated circuit intermediate 2, is effective to bleed off charges to electrode 3 upon which the integrated circuit 2 is placed. The processing chamber 4 is equipped with another electrode 5 and such additional standard equipment as is required for its function.

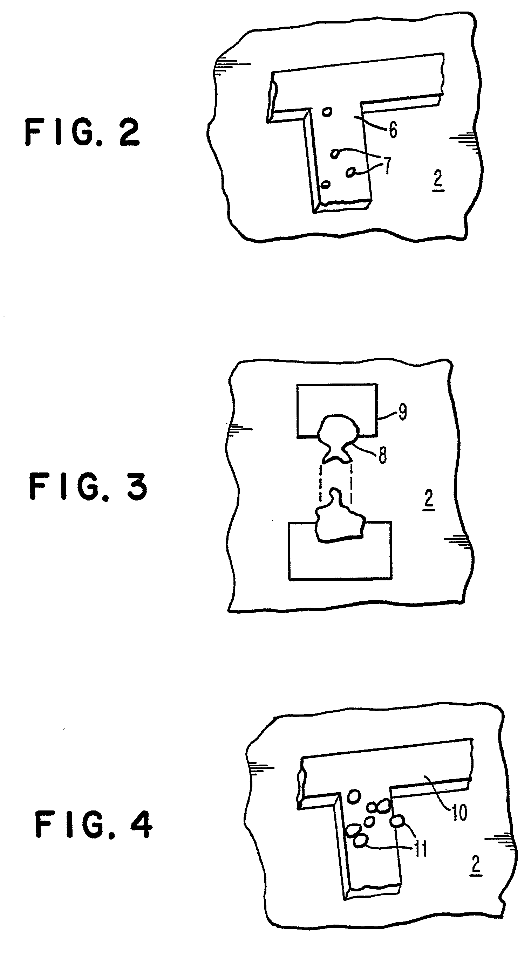

Figures 2-4 illustrate failure mechanisms related to charge buildup. In FIG. 2, exhibiting "SiO bumps", pattern 6 of metallisation over SiO insulation on intermediate 2 has SiO bumps 7 which interfere with mechanical strength and electrical conductivity. In FIG. 3, exhibiting "resistor blowout", resistance material 8 has a discontinuity in its desired connection between areas of metallisation 9 on intermediate 2. In FIG. 4, exhibiting "black death", corroded dark patches 11 appear on metallisation 10 on intermediate 2.

To provide a suitable photoconductive photoresist, a common photoresist containing a diazoketone as the photoactive compound (examples are AZ 1350, AZ 1450J, AZ 1350SF) is compounded with a photoconductor by addition of an amine with low ionisation potential, diazobicyclooctane (DABCO). Other amines with low ionisation potential (including primary, secondary or tertiary amines) form a charge transfer complex with the ketone function of the photoactive compound. This complex imparts conductive properties to the film in the presence of light. The photoresist retains its usual properties for exposure on normal tools used in the trade, but in the plasma discharge, RIE, e-beam evaporation or sputter deposition processes the photoconducting material conducts away the charge to the cathode through the normal means of wafer attachment.

Charges may be dissipated via the semiconductor substrate to the electrode which is the source of reference potential (usually ground) for elimination of charge build-up. Depending upon the characteristics of the tool and of the integrated circuit intermediate, it may be advantageous to connect the photoconducting photoresist complex to ground by a conductive metal clip or probe.

In a test vehicle, resistors covered by normal photoresist were blown off the wafer during SiO evaporation. Identical wafers covered with photoconductive resist showed no damage. Metal lines covered by normal resist showed severe grain growth, while identical lines covered by photoconductive resist showed no damage. Use of photoconductive photoresist eliminates many problems caused by charging of wafers during processing.

Using photoconducting photoresist in the processing, bleeding charges away through electrodes already present in the process, minimises failure mechanisms such as SiO bumps, resistor blowout and black death which are related to charge buildup. The photoconductivity exhibits no apparent undesirable side effects.

The preferred photoconducting photoresist complex is prepared as follows:

The photoconductivity complexing agent is prepared by dissolving 0.5-5 wt % DABCO (or other amine) in a suitable solvent which is miscible with the commercial resist solution to be used as the photoresist complexing agent. Such a solvent for AZ 1350SF, 1350J or 14SOJ is commercially available AZ THINNER. The photoconductivity complexing agent solution of amine/solvent is added slowly with agitation (ultrasonic or mechanical stirring) to the photoresist complexing agent resist solution. The resulting solution must be agitated or stirred for 1-2 hours to complete the dispersion of the amine in the resist. The resulting photoconductive photoresist complex solution appears darker in colour than the standard resist solution as a result of the complex formation. The solution is then filtered to remove any sediment, leaving the photoconductive photoresist complex solution ready for use.

The process of using the photoconductive photoresist complex is as follows:

The photoconductive photoresist complex solution is spun on the wafer (or other integrated circuit process intermediate) in the normal manner to obtain the desired thickness. The photoconductive photoresist complex layer is exposed using standard optical exposure systems available in the industry. Normal resist developer is used to develop the resist patterns. The longer wavelength absorption of the photoconductive photoresist complex changes the exposure/develop conditions in minor ways. For the photoconductive photoresist complex of AZ1350SF with DABCO there is a shorter development time for a given exposure, than the time normally recommended for AZ1350SF alone. With these minor optimisations of the process window parameters, the photoconductive photoresist may be used in a similar manner to any standard photoresist.

The photoconductivity peak and the photoresistivity peak of the photoconductive photoresist are at different wavelengths. This permits separate control of photoconductivity, by a floodlight (photoconductivity wavelength) over the area of a chip or wafer, providing photons to produce the requisite conductivity without affecting the photoresistivity. This is roughly analogous (as regards the photoresist) to the coloured light of a darkroom, providing useful illumination at a harmless wavelength. Conversely, the photoresist exposure light may be selected to have a finite photoconductivity production capability, from zero to significant photoconductivity, according to the needs of the application.

The wavelength of absorption is determined by the difference between the ionisation potential of the amine and the electron affinity of the acceptor compound (diazoketone in the photoresist). This property allows the optimum wavelength for the photoconductivity to be tailored for particular light sources. This allows the photoresist to be conductive in a cleanroom/yellow light situation and thus gives protection against electrostatic damage to the devices. It also allows use where only a various band light source is permissible. Such a situation might be in an electron-beam exposure tool.

In general, barring chemical incompatibility of the photoconductor to other components of the photoconductive photoresist complex, any of the several available photoresists comprised in the definition of Claim 1 may be used as photoresist complexing agent, together with the amine photoconductivity complexing agent, for use as a photoconductive photoresist complex in accordance with the invention. So long as the photoconductivity complexing agent does not adversely react nor block light necessary for photoresist exposure, a range of photoconductive material may be substituted for that of the preferred embodiment.

## Claims

1. A process for manufacturing an integrated circuit comprising the steps of providing a photoresist layer (2) on an integrated circuit process intermediate and subsequently treating the integrated circuit process intermediate, with photoresist layer, to a patterning process step by mounting it on an attachment mechanism for processing in an environment of significant electric potential; the process being characterised by the photoresist comprising a diazo ketone photosensitivity complexing agent and an amine photoconductivity complexing agent of low ionisation potential and such that the photoconductivity and photosensivity peaks of the photoresist are at different wavelengths; and means connecting the photoresist layer to a drain electrode (3), at a reference potential, for charges resulting from the environment of significant electric potential.

2. A process as claimed in claim 1, in which the photoconductivity complexing agent comprises diazobicyclooctane.

3. A process as claimed in claim 1 or claim 2 in which the means connecting the photoresist layer to the drain electrode comprises floodlight means for providing surface light to the integrated circuit process intermediate at a wavelength selected for significant photoconductivity but insignificant photoresistivity of the photoresist.

## Patentansprüche

1. Verfahren zur Herstellung eines integrierten Schaltkreises mit den Verfahrensschritten des Schaffens einer Photoresistschicht (2) auf einem Verfahrenszwischenprodukt des integrierten Schaltkreises und dem anschließenden Behandeln des mit der Photoresistschicht versehenen Verfahrenszwischenproduktes des integrierten Schaltkreises in einem musterbildenden Verfahrensschritt, bei dem es auf einer Anschlußhaltevorrichtung angeordnet wird, um in einer Umgebung mit einem signifikanten elektrischen Potential behandelt zu werden; wobei das Verfahren gekennzeichnet ist durch den Photoresist, der einen ein Diazoketon enthaltenden lichtempfindlichen Komplexbildner und einen ein Amin enthaltenden photoleitenden Komplexbildner mit einem niedrigen Ionisationspotential umfaßt, so daß die Spitzenwerte der Photoleitung und der Lichtempfindlichkeit des Photoresist bei verschiedenen Wellenlängen auftreten; und durch Mittel, die die Photoresistschicht für Ladungen, die aus der Umgebung mit dem signifikanten elektrischen Potential stammen, mit einer auf einem Referenzpotential liegenden Drain-Elektrode (3) verbinden.

2. Verfahren nach Anspruch 1, bei dem der photoleitende Komplexbildner Diazo-bi-cyclo-oktan umfaßt.

3. Verfahren nach Anspruch 1 oder Anspruch 2, bei dem die die Photoresistschicht mit der Drain-Elektrode verbindenden Mittel Scheinwerferlichtmittel umfassen, um eine Oberflächenbeleuchtung auf dem Verfahrenszwischenprodukt des integrierten Schaltkreises bei einer Wellenlänge zu schaffen, die für eine signifikante Photoleitung aber eine nicht-signifikante Photoempfindlichkeit des Photoresists ausgewählt ist.

## Revendications

1. Procédé pour la fabrication d'un circuit intégré, comprenant les opérations d'application d'une couche photosensible (2) sur un produit intermédiaire de fabrication de circuit intégré, puis de traitement du produit intermédiaire de fabrication de produit intégré, comportant la couche photosensible, dans une opération de définition de configuration par montage dudit produit sur un mécanisme de fixation pour le traitement dans un environnement de potentiel électrique significatif, le procédé étant caractérisé en ce que la matière photosensible comprend un agent complexant de photosensibilité de type diazocétone et un agent complexant de photoconductivité de type amine de faible potentiel d'ionisation et tels que les pics de photoconductivité et de photosensibilité de la matière photosensible sont situés à différentes longueurs d'onde, et en ce que des moyens connectent la couche photosensible à une électrode de drain (3), qui est à un potentiel de référence, pour les charges résultant de l'environnement de potentiel électrique significatif.

2. Procédé suivant la revendication 1, dans lequel l'agent complexant de photoconductivité est le diazobicyclooctane.

3. Procédé suivant la revendication 1 ou la revendication 2, dans lequel les moyens connectant la couche photosensible à l'électrode de drain comprennent des moyens d'éclairage pour fournir une lumière de surface au produit intermédiaire de fabrication de circuit intégré, à une longueur d'onde choisie pour une photoconductivité significative mais une photorésistivité négligeable de la matière photosensible.

# F I G. 1

FIG. 2

FIG. 3

FIG. 4